Europäisches Patentamt

European Patent Office

Office européen des brevets

(19)

(11) **EP 1 150 339 A1**

(12) **EUROPEAN PATENT APPLICATION**
published in accordance with Art. 158(3) EPC

(43) Date of publication:
**31.10.2001 Bulletin 2001/44**

(21) Application number: **00971815.6**

(22) Date of filing: **07.11.2000**

(51) Int Cl.$^7$: **H01L 21/02**, H01L 21/304

(86) International application number:
**PCT/JP00/07803**

(87) International publication number:
**WO 01/35450 (17.05.2001 Gazette 2001/20)**

(84) Designated Contracting States:
**AT BE CH CY DE DK ES FI FR GB GR IE IT LI LU MC NL PT SE TR**

(30) Priority: **08.11.1999 JP 31676499**

(71) Applicant: **Nikko Materials Company, Limited Tokyo 105-8407 (JP)**

(72) Inventor: **WATATANI, Kenichi**
**Nikko Mater.Co.Ltd. Isohara Plant**
**Kitaibaraki-shi, Ibaraki 319-1535 (JP)**

(74) Representative: **Rackham, Stephen Neil**
**GILL JENNINGS & EVERY,**
**Broadgate House,**
**7 Eldon Street**
**London EC2M 7LH (GB)**

(54) **COMPOUND SEMICONDUCTOR WAFER**

(57) The invention relates to a chamfered portion on a peripheral edge portion of a semiconductor wafer. Both of a rear surface and a surface of the chamfered portion of the wafer are non mirror surfaces, and the rear surface and the surface of the chamfered portion are processed so that

(average surface roughness of chamfered portion) - (average surface roughness of rear surface) ≦ 5 μm.

## FIG. 1

**Description**

TECHNICAL FIELD

The present invention relates to a technique of chamfering a peripheral edge portion of a compound semiconductor wafer, in particular, a technique for effectively preventing wafer breakage caused by impact during transportation.

BACKGROUND ART

Generally, a plurality of wafers are transported at one time, accommodated in pocket shaped storage portions of a wafer carrier made of PFA (perfluoroalkoxyfluororesin) or polypropylene. Because the wafers are moved vertically and vibrated during such transportation, the peripheral edge portions of the wafers touch guides of the storage portions frequently and get impact locally. From portions getting impact locally, Micro-cracks tend to be generated, and then sudden cleavages can occur to lead to wafer breakage. Therefore, it was earlier suggested a technique of chamfering a peripheral edge portion of a wafer to prevent concentration of stress exerted on the peripheral edge portion for reducing wafer breakage, and the technique enables impact resistance of wafers to increase, so that wafer breakage originated from peripheral portions is reduced. Furthermore, mirror finishing chamfered peripheral edge portions of wafers (edge polishing) can effectively prevent wafer breakage originated from peripheral edge portions of the wafers.

However, the above-described edge polishing is performed after mechanically rubbing (lapping) surfaces of chamfered wafers by using lapping fluid containing lapping abrasives of fine particles. Furthermore, in the edge polishing, both surfaces or single surfaces of wafers are held with a holder such as a chuck, and the wafers are rotated for a long time to abrade chamfered edge portions on an abrasive cloth (polishing pad) or an abrasive tape. Therefore, with wafers made of a very brittle material such as compound semiconductor of InP or the like, the edge polishing causes another processing deteriorated layer on front and rear surfaces of such wafers, and then facilitates wafer breakage.

Moreover, such wafers require to remove the processing deteriorated layers formed by the edge polishing. Therefore, the amount of surface lapping, polishing performed afterward is increased, and then machining time becomes longer and the productivity is decreased. Furthermore, because such wafers need to be thicker when slicing from an ingot, considering machining loss during lapping, polishing of the processing deteriorated layer, the yield of wafers from an ingot is reduced. As described above, edge polishing for such wafers is demanding with a poor yield, and then causes a problem that the price of such wafers become expensive.

If wafers are relatively solid, such as silicon wafers, the edge polishing dose not deeply form processing deteriorated layers on surfaces of the wafers, and then can effectively prevent wafer breakage. However, if wafers are brittle, such as compound semiconductor wafers, because the edge polishing deeply forms processing deteriorated layers and then causes the previously described problems, the edge polishing is not generally adopted.

The present invention is developed to solve the above-described problems, and an object of the invention is to provide compound semiconductor wafers, to which the edge polishing is unsuitable, wherein wafer breakage originated from peripheral edge portions is effectively prevented.

DISCLOSURE OF THE INVENTION

To achieve the above-described object, the inventor conducted assiduous research on InP wafers, which is one of group III-V compound semiconductor, seeking for the reason of wafer breakage. As a result, it was found that wafer breakage occurred when transporting InP wafers or the like is tend to happen at a boundary between a chamfered portion and a rear surface of a wafer, and a broken section is a cleavage plane.

According to wafers of group III-V compound semiconductor such as InP or the like, there is a method of cutting out rectangle wafers from a round wafer wherein a round wafer is cut by using a crystal property of cleavage instead of using cutting device such as a dicing saw or the like. That is, a tiny cut is made at a peripheral portion of a round wafer, and then a cleavage is occurred by properly impacting on the tiny cut. As described above, compound semiconductor wafers such as InP wafers or the like have a physical property that a cleavage occurs by impacting on a cut. The inventor inferred from the property that the reason that a broken section was a cleavage plane would be that a wafer had flaws like tiny cuts at a peripheral edge portion and impact was given on the flaws.

The inventor conducted further experiments focusing on rear surfaces and chamfered portions of wafers, based on the above-described inference. As a result, it was found that when there is a slight difference in average surface roughness between the rear surface and the chamfered portion, the difference affects a ratio of wafer breakage. If surface roughness of a chamfered portion is rougher than that of a rear surface by a certain value, a wafer more likely breaks because of cleavages caused by impact during transportation or the like. Therefore, the present invention was completed.

That is, the present invention relates to a chamfered peripheral edge portion of a compound semiconductor wafer. According to the invention, a rear surface and a surface of a chamfered peripheral edge portion of a wafer are both non mirror, and the rear surface and the chamfered portion are processed so that

$$\text{(average surface roughness of chamfered portion) - (average}$$

$$\text{surface roughness of rear surface)} \leqq 5 \ \mu\text{m: a conditional}$$

$$\text{formula (1)}.$$

Preferably, the average surface roughness of the chamfered portion may be determined as an average surface roughness of a portion from the middle of a peripheral side edge of the wafer to a rear surface of the wafer, which is a portion of the chamfered portion. That is, the rear surface and the chamfered portion may be processed so that

$$\text{(average surface roughness of portion from the middle of}$$

$$\text{chamfered portion to rear surface) - (average surface}$$

$$\text{roughness of rear surface)} \leqq 5 \ \mu\text{m: a conditional formula}$$

$$(2).$$

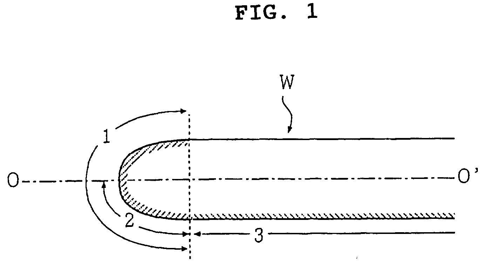

Hereinafter, each portion of the above-described conditional formulas will be explained in detail with reference to FIG. 1 that is a schematic cross-sectional view showing a chamfered wafer W, on which the process of chamfering was performed. In FIG. 1, numeral 1 denotes "chamfered portion" of the conditional formula 1. Numeral 2 denotes "portion from the middle of chamfered portion to rear surface" of the conditional formula 2. Numeral 3 denotes "rear surface" of the conditional formulas 1 and 2.

Even if a wafer is made of a brittle material such as a compound semiconductor, by processing a rear surface and a chamfered portion of the wafer to meet the conditional formula 1 or 2, it is possible to increase impact resistance of the wafer relatively easily. Therefore, it is possible to suppress wafer breakage caused by impact during handling such as transportation or the like.

Although the present invention is applicable to any compound semiconductor, which is a brittle material, in particular, the invention can have remarkable effect on InP wafers.

BRIEF DESCRIPTION OF DRAWINGS

FIG. 1 is a schematic cross-sectional view showing a chamfered semiconductor wafer.
FIGS. 2 are schematic views showing a process of chamfering by using a chamfering machine.
FIG. 3 shows a template for chamfering, used for an embodiment of the present invention.
FIG. 4 is a plane view showing measuring points of a rear surface and a chamfered portion of the wafer.
FIG. 5 is a perspective view of a wafer carrier.

PREFERRED EMBODIMENT

Hereinafter, a preferred embodiment of the present invention will be described in detail with reference to the figures.

As the semiconductor wafers according to the embodiment of the invention, InP wafers that are 50.8mm (2 inches) on diameter and $350 \pm 10 \ \mu\text{m}$ on thickness are used. The wafers undergo a predetermined chamfering, using a chamfering machine (W2000M) produced by Tokyo Seimitsu co., LTD. so that peripheral edge portions of the wafers are curved as shown in FIG. 1. Thereafter, the chamfered wafers undergo predetermined etching and lapping, polishing to obtain single side polished wafers.

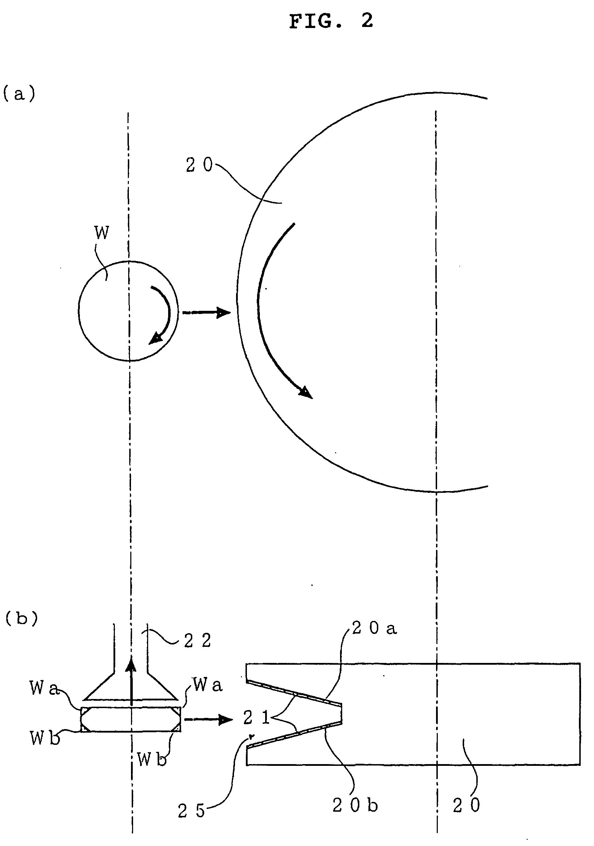

FIG. 2 is a schematic view showing a process of chamfering by using a chamfering machine, wherein (a) is a top view and (b) is a side view. The chamfering machine comprises a round chamfering grinding wheel 20 and a groove 25 along an outer periphery on a cross section of the chamfering grinding wheel 20.

Chamfering was performed in the following way. The wafer W, sliced from an ingot, was held by a single side chucking by using a vacuum chuck 22. While the grinding wheel 21, on which diamond grains 21 of grain size # 1500 were electrodeposited, was rotated at 3600r.p.m., an upper side Wa of a peripheral edge portion of the wafer was pressed to and ground on an inclined plane 20a of the groove 25 on the cross section of the grinding wheel 20, and a lower side Wb of the peripheral edge portion of the wafer was pressed to and grounded on an inclined plane 20b, to be chamfered.

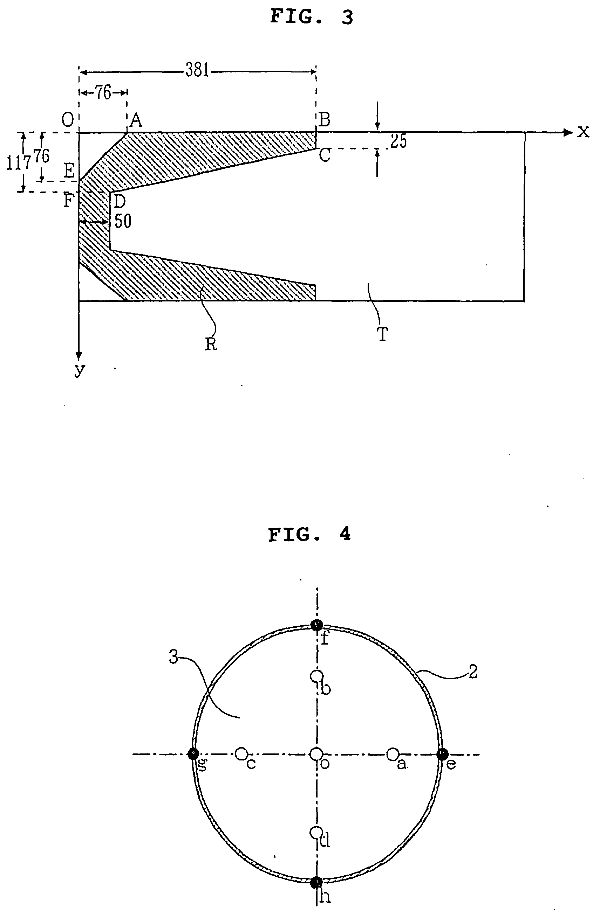

In this case, the InP wafers were ground for chamfering by using a template T (see FIG. 3) that was made according to a chamfering template for silicon in SEMI

(Semiconductor Equipment and Materials Incorporation)

standard M5-83.

The template T in FIG. 3 was designed for a wafer of thickness 350 $\mu$m, wherein OA=76 $\mu$m, OB=381 $\mu$m, BC=25 $\mu$m, OE=76 $\mu$m, DF=50 $\mu$m, and OF=117 $\mu$m. The wafer was chamfered so that a contour line of a cross section of a chamfered portion of the wafer was within a shaded area R in FIG. 3, comparing the template T and the contour line of the cross section of the chamfered portion. Practically, inspection was carried out to ensure that the contour line of the cross section of the chamfered portion of the wafer was within the shaded area R in the following way. The contour line of the cross section of the chamfered wafer W was projected on the template T, and a position of the wafer W was adjusted so that a front surface of the cross section of the wafer was on an x-axis and an outermost portion of the chamfered portion was tangent to a y-axis.

After the predetermined grinding for chamfering was performed in the above-described way, the wafer had a processing deteriorated layer and formed a large warp. Therefore, the processing deteriorated layer was removed by etching to remove the warp. Thereafter, the etched wafer was roughly processed (lapping) on a turn table made of glass or the like with feeding lapping fluid containing, for example, silica, cerium oxide powder abrasive or the like. As a result, flat rough surfaces, free from saw marks made during slicing, were obtained. Etching was performed again to remove processing deteriorated layers caused by lapping and abrasive particles embedded in the surfaces of the wafer.

Thereafter, high-precision processing (polishing) and etching were repeated alternatively, and then final rinsing was performed. Thus, the desired wafer, that is, the wafer wherein a difference in surface roughness between the rear lapped and etched surface and the chamfered portion was within 5 $\mu$m was obtained.

As described above, according to the method for manufacturing a wafer of the embodiment, etching to remove processing deteriorated layers is performed just after chamfering, and edge polishing is not performed after the etching, so that another processing deteriorated layer is not made. Therefore, it is possible to manufacture high quality semiconductor wafers by processes equal to earlier developed processes.

Next, results of a test for impact resistance of the semiconductor wafer according to the present invention will be explained.

By performing predetermined chamfering and etching in the above-described way, a batch of 25 wafers was manufactured so that front surfaces of the wafers were processed to be mirror surfaces and rear surfaces of the wafers are processed to be rough (lapped and etched) surfaces.

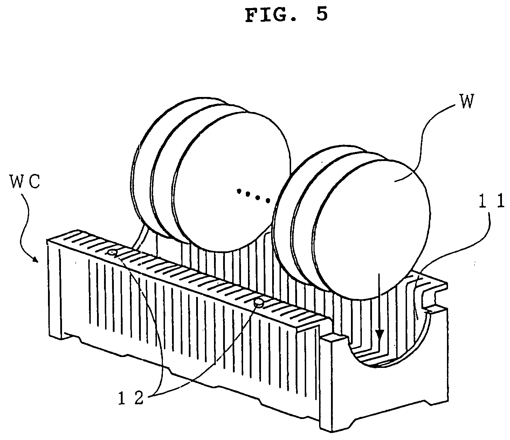

The 25 obtained wafers were gauged for surface roughness of the rear surfaces and the chamfered portions of the wafers at measuring points as shown in FIG. 4, by using a contact type gauge. In this case, average surface roughness of a rear surface was defined as an average value of Rmaxes measured at the center of the rear surface o as shown in FIG. 4, and four points of a, b, c and d that were on crisscross lines crossing on the center o and equidistant from the center o. Average surface roughness of a chamfered portion was defined as an average value of Rmaxes measured at four points of e, f, g and h that were intersections of an area 2, which is a portion from the middle of a chamfered portion to a rear surface, and the crisscross lines crossing on the center o. Rmax is defined as |maximum peak absolute value| + |maximum valley absolute value| when measurement is conducted at an area within 50 $\mu$m of each measuring point.

According to the embodiment, Rmaxes were measured at the above-described measuring points, and a surface roughness was defined as an average value of them. However, measuring points are not limited by the above-described points. The measuring points a to h do not need to be exactly on the crisscross lines crossing on the center o, but may be around the crisscross lines, as a matter of course. The surface roughness of the chamfered portion may be measured at a portion from the middle of the chamfered portion to a front surface of the wafer. Although the measurement may be conducted at more measuring points, the measuring points preferably contain at least the above-described points.

[TABLE 1]

| (1) average surface roughness of rear surface | 1.8 to 2.3 μm |
|---|---|
| (2) average surface roughness of chamfered portion | 5.9 to 6.7 μm |
| (2) - (1) | 4.1 to 4.4 μm |

As shown in Table 1, the value of (average surface roughness of chamfered portion) - (average surface roughness of rear surface) was from 4.1 to 4.4μm.

These 25 wafers as test samples were subjected to a test for impact resistance. A wafer carrier WC made of PFA as shown in FIG. 5 was used for the test for impact resistance.

Firstly, each wafer W was accommodated in a pocket type storage 11 of the wafer carrier WC. Next, an empty uniform wafer carrier was put on a top of the wafer carrier WC accommodating the wafers so that the empty wafer carrier was upside down. These carriers were combined to each other by attaching concave and convex portions 12 on the top of each of the carriers. The combined carrier set was turned over so that the accommodated wafers ware moved from one carrier to the other carrier. The movement was repeated until the wafers broke. As a result, one of the 25 wafers was broken at the 1387th movement.

(COMPARATIVE EXAMPLE 1)

In comparative example 1, wafers were processed so that a difference in average roughness between a rear surface and a chamfered portion was about 6μm. Therefore, grinding for chamfering were performed by using the previously mentioned grinding machine having a grinding wheel on which diamond grains of grain size #1000 were electrodeposited while the rotation number of the grinding wheel was 2500r.p.m. Thereafter, etching with etchant of bromine-methanol system was performed, and then predetermined processing (lapping and polishing) was performed, so that the wafers were processed to have front surfaces that were mirror surfaces and rear surfaces that were rough (lapped and etched) surfaces. As a result, the 25 desired wafers were obtained.

The 25 obtained wafers were measured for surface roughness of the rear surfaces and the chamfered portions in the same way as the above-described embodiment, and table 2 shows the result.

[TABLE 2]

| (1) average surface roughness of rear surface | 1.7 to 2.2μm |
|---|---|
| (2) average surface roughness of chamfered portion | 7.5 to 8.4μm |
| (2) - (1) | 5.8 to 6.2 μm |

The 25 wafers as test samples were subjected to the same test for impact resistance as the above-described embodiment, and then one of them broken at the 833rd movement.

(COMPARATIVE EXAMPLE 2)

In comparative example 2, the wafers were processed so that a difference in average roughness between a rear surface and a chamfered portion was 8 μm or more. Therefore, grinding for chamfering was performed by using the previously mentioned grinding machine having a grinding wheel on which diamond grains of grain size #800 were electrodeposited, while the rotation number of the grinding wheel was 1600r.p.m. Thereafter, etching with etchant of bromine-methanol system was performed, and then predetermined processing (lapping and polishing) was performed, so that the wafers were processed to have front surfaces that were mirror surfaces and rear surfaces that were rough (lapped and etched) surfaces. As a result, the 25 desired wafers were obtained.

The 25 wafers were measured for surface roughness of the rear surfaces and the chamfered portions in the same way as the previously described embodiment, and table 3 shows the results.

[TABLE 3]

| (1) average surface roughness of rear surface | 2.0 to 2.4μm |
|---|---|
| (2) average surface roughness of chamfered portion | 10.1 to 11.3μm |
| (2) - (1) | 8.1 to 8.9 μm |

The 25 wafers as test samples were subjected to the same test for impact resistance as the previously described embodiment, and two of them were broken at the 781st movement.

The results of the whole tests for impact resistance are shown in Table 4. The table shows that the number of the movements until wafer breakage increased, as the difference between (average surface roughness of rear surface) and (average surface roughness of chamfered portion) decreased. Moreover, when the difference was not more than 5 µm, the number of the movements remarkably increased and impact resistance of the wafers was improved. That is, making the value, (average surface roughness of rear surface) - (average surface roughness of chamfered portion), not more than 5 µm enables to improve impact resistance of wafers and effectively prevent wafer breakage during handling such as transportation or the like.

The values of (surface roughness of rear surface) - (surface roughness of chamfered portion) of the wafers used for the previously described test for impact resistance were 4.1 to 4.4 µm. However, it is preferable that the value is as small as possible.

[TABLE 4]

| (average surface roughness of rear surface) - (surface roughness of chamfered portion) | the number of movement until wafer breakage (time) | the number of broken wafer (sheet) |
|---|---|---|
| 5 µm or less (4.1 to 4.4 µm) | 1387 | 1/25 |
| about 6 µm (5.8 to 6.2 µm) | 883 | 1/25 |
| 8 µm or more (8.1 to 8.9 µm) | 781 | 2/25 |

According to the present invention, even if a wafer is made of a brittle material such as a compound semiconductor, it is comparatively easy to improve impact resistance of the wafer by controlling surface roughness of a chamfered portion of the wafer. Therefore, the invention enables to suppress wafer breakage caused by impact during handling such as transportation or the like.

INDUSTRIAL APPLICABILITY

The compound semiconductor wafer according to the present invention is not limited to an InP wafer. The present invention is applicable to wafers of group III-V compound semiconductor, such as GaAs, InSb or the like, and wafers of compound semiconductor other than group III-V, if the wafers are round shaped.

Moreover, if a shape of a chamfered portion is a curved shape according to a recommended template of SEMI standards, the same effect can be obtained as a matter of course. Even if a peripheral portion has a special shape, such as stairs-like structure or the like, it is possible to obtain the same effect by controlling surface roughness of the chamfered portion.

**Claims**

1.   A compound semiconductor wafer comprising: a peripheral edge portion being chamfered; and a rear surface, wherein both of the rear surface and a surface of the chamfered peripheral edge portion are non mirror polished, and

(average surface roughness of the chamfered portion)

- (average surface roughness of the rear surface) $\leqq$ 5 µm.

2.   The compound semiconductor wafer as claimed in claim 1, wherein an average surface roughness of the chamfered portion is an average surface roughness of a portion from a middle of a peripheral side edge of the wafer to the rear surface of the wafer, which is a portion of the chamfered portion.

3.   The compound semiconductor wafer as claimed in claim 1 or claim 2, wherein the semiconductor wafer is an InP wafer.

# FIG. 1

# FIG. 2

(a)

(b)

## FIG. 3

## FIG. 4

FIG. 5

## INTERNATIONAL SEARCH REPORT

| | International application No. |
|---|---|
| | PCT/JP00/07803 |

| A. CLASSIFICATION OF SUBJECT MATTER |
|---|
| Int.Cl⁷   H01L21/02, H01L21/304, 601 |

According to International Patent Classification (IPC) or to both national classification and IPC

| B.   FIELDS SEARCHED |
|---|

Minimum documentation searched (classification system followed by classification symbols)
Int.Cl⁷   H01L21/02, H01L21/304, 601

Documentation searched other than minimum documentation to the extent that such documents are included in the fields searched

| Jitsuyo Shinan Koho | 1922-1996 | Toroku Jitsuyo Shinan Koho | 1994-2001 |
|---|---|---|---|
| Kokai Jitsuyo Shinan Koho | 1971-2001 | Jitsuyo Shinan Toroku Koho | 1996-2001 |

Electronic data base consulted during the international search (name of data base and, where practicable, search terms used)

| C.   DOCUMENTS CONSIDERED TO BE RELEVANT |
|---|

| Category* | Citation of document, with indication, where appropriate, of the relevant passages | Relevant to claim No. |
|---|---|---|
| A | JP, 11-135474, A (Komatsu Electronic Metals Co., LTD.), 21 May, 1999 (21.05.99), Full text; Figs. 1 to 3   (Family: none) | 1-3 |
| A | JP, 7-6984, A (Toshiba Corporation), 10 January, 1995 (10.01.95), Full text; Figs. 1 to 5   (Family: none) | 1-3 |
| A | JP, 5-291215, A (Mitsubishi Materials Corporation, Mitsubishi Materials Silicon Corp.), 05 November, 1993 (05.11.93), Full text; Figs. 1 to 4   (Family: none) | 1-3 |
| A | JP, 4-98247, A (Shin Etsu Handotai Co., Ltd.), 27 March, 1992 (27.03.92), Full text; Figs. 1 to 5   (Family: none) | 1-3 |
| A | JP, 3-1535, A (Asahi Glass Co., Ltd.), 08 January, 1991 (08.01.91), Full text   (Family: none) | 1-3 |

| ☒ | Further documents are listed in the continuation of Box C. | ☐ | See patent family annex. |
|---|---|---|---|

| * | Special categories of cited documents: |
|---|---|
| "A" | document defining the general state of the art which is not considered to be of particular relevance |
| "E" | earlier document but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| 30 January, 2001 (30.01.01) | 06 February, 2001 (06.02.01) |

| Name and mailing address of the ISA/ Japanese Patent Office | Authorized officer |
|---|---|
| Facsimile No. | Telephone No. |

Form PCT/ISA/210 (second sheet) (July 1992)

**EP 1 150 339 A1**

## INTERNATIONAL SEARCH REPORT

International application No.

PCT/JP00/07803

C (Continuation). DOCUMENTS CONSIDERED TO BE RELEVANT

| Category* | Citation of document, with indication, where appropriate, of the relevant passages | Relevant to claim No. |
|---|---|---|
| A | JP, 61-127130, A (Mitsubishi Electric Corporation), 14 June, 1986 (14.06.86), Full text; Figs. 1 to 3   (Family: none) | 1-3 |

Form PCT/ISA/210 (continuation of second sheet) (July 1992)

12